Europäisches Patentamt

European Patent Office

Office européen des brevets

(11) Veröffentlichungsnummer: **0 241 589 B1**

# EUROPÄISCHE PATENTSCHRIFT

(45) Veröffentlichungstag der Patentschrift: **28.08.91**

(51) Int. Cl.⁵: **G01N 21/00, G01N 21/84**

(21) Anmeldenummer: **86116845.8**

(22) Anmeldetag: **03.12.86**

(54) **Testglaswechsler zur optischen Messung von Schichteigenschaften in Vakuumbeschichtungsanlagen.**

(30) Priorität: **14.02.86 DE 3604624**

(43) Veröffentlichungstag der Anmeldung:
**21.10.87 Patentblatt 87/43**

(45) Bekanntmachung des Hinweises auf die Patenterteilung:
**28.08.91 Patentblatt 91/35**

(84) Benannte Vertragsstaaten:
**AT CH DE ES FR GB LI NL SE**

(56) Entgegenhaltungen:
**DE-A- 2 932 483**

(73) Patentinhaber: **LEYBOLD AKTIENGESELL-SCHAFT**
**Wilhelm-Rohn-Strasse 25**
**W-6450 Hanau am Main 1(DE)**

(72) Erfinder: **Lehnert, Walter**
**Breslauerstrasse 26**
**W-6460 Gelnhausen -2(DE)**
Erfinder: **Zültzke, Walter**
**Kilianstädterstrasse 1**
**W-6457 Maintal -4(DE)**

(74) Vertreter: **Zapfe, Hans, Dipl.-Ing.**
**Am Eichwald 7**
**W-6056 Heusenstamm 2 Rembrücken(DE)**

**Beschreibung**

Die Erfindung betrifft einen Testglaswechsler zur optischen Messung von Schichteigenschaften in Vakuumbeschichtungsanlagen, die einen beweglichen Substrathalter für die Führung mindestens eines Substrats auf einer Bahn durch mindestens einen Strom eines Beschichtungsmaterials aufweisen, mit einer am Substrathalter gelagerten und mit diesem beweglichen und relativ zum Substrathalter in sich beweglichen Halterung für die Aufnahme mehrerer Testgläser und mit einer Steuereinrichtung für die Einführung jeweils eines Testglases in einen Strahlengang einer Meßvorrichtung und in den mindestens einen Strom des Beschichtungsmaterials.

Durch die DE-A-29 32 483 ist ein Testglaswechsler der eingangs beschriebenen Gattung bekannt, bei dem durch ein vorgegebenes Übersetzungsverhältnis eine ständige Korrelation der Drehzahlen der Testglashalterung und des Substrathalters gegeben ist. Eine Messung ist daher nur bei Stillstand des Substrathalters in einer vorgegebenen Beschichtungsposition durchzuführen, d.h. dann, wenn die zu beschichtenden Substrate und das ausgewählte Testglas gleichzeitig dem Strom eines Beschichtungsmaterials ausgesetzt sind, indem sie beispielsweise im Einflußbereich einer Zerstäubungskatode liegen. Während dieses Stillstandes muß natürlich weiterhin die Bedingung erfüllt sein, daß das betreffende Testglas, eine Öffnung im Substrathalter, mindestens eine Öffnung in der Vakuumkammer und der Strahlengang der Meßvorrichtung fluchten, d.h. daß ihre Mittelpunkte auf einer gemeinsamen optischen Achse liegen. Das Verhältnis der Schichtdicken auf dem Testglas einerseits und auf den gleichzeitig beschichteten Substraten andererseits unterliegt dabei natürlich der von der Beschichtungsquelle vorgegebenen Schichtdickenverteilung, do daß die Meßwerte nicht unbedingt mit dem tatsächlichen Schichtdicken übereinstimmen. Bei der bekannten Lösung ist das ausgewählte Testglas in der Mitte jeweils einer Gruppe von gleichzeitig beschichteten Substraten angeordnet, d.h. an einer Stelle, an der die Niederschlagsrate des Schichtmaterials in der Regel besonders groß ist. Die bekannte Lösung setzt außerdem die gruppenweise Zusammenfassung von Substraten auf einzelnen Substrattellern voraus, die ihrerseits wieder in dem karussellartigen Substrathalter gelagert sind. Diese Bauweise macht es weiterhin erforderlich, daß jeder Gruppe von Substraten bzw. jeder Beschichtungsstation (in der Regel sind mehrere Beschichtungsstationen für alternierende Schichtfolgen vorgesehen) ein eigener Testglaswechsler und eine eigene optische Meßvorrichtung zuzuordnen sind, durch die der konstruktive Aufwand beträchtlich vergrößert wird. Ein solcher Konstruktionsaufwand, die durch die starre Kopplung des Testglaswechslers mit dem Substrathalter erzwungene diskontinuierliche Betriebsweise (ohne Relativbewegung zwischen den Substraten und der Beschichtungsquelle) sowie die Abweichungen zwischen den Meßergebnissen und den Eigenschaften der Substrate sind jedoch für zahlreiche Anwendungsfälle nicht tolerierbar.

Der Erfindung liegt daher die Aufgabe zugrunde, einen Testglaswechsler der eingangs beschriebenen Gattung dahingehend zu verbessern, daß der konstruktive Aufwand der gesamten Vakuumbeschichtungsanlage verringert, eine kontinuierliche Betriebsweise ermöglicht und Abweichungen zwischen den Meßergebnissen und den Eigenschaften der Substrate auf ein Minimum reduziert werden.

Die Lösung der gestellten Aufgabe erfolgt bei dem eingangs beschriebenen Testglaswechsler erfindungsgemäß dadurch, daß die Steuereinrichtung ein Schrittschaltwerk ist, durch das bei einem im Verhältnis zu einer vollen Bahnlänge des Substrathalters kleinen Weg jeweils ein Testglas in eine relativ zum Substrathalter stationäre Position umschaltbar ist, in der es mit den Substraten für eine vorgebbare Anzahl von Umdrehungen des Substrathalters alternierend nacheinander durch den Strahlengang der Meßvorrichtung und durch den Strom des Beschichtungsmaterials hindurchführbar ist.

Bei der Bewegung des Substrathalters kann es sich um eine lineare, oszillierende Bewegung oder um eine Drehbewegung handeln. Im zuletzt genannten Fall ist die "Bahnlänge" dann der Umfang bei einem Drehwinkel von 360 Grad.

Durch die erfindungsgemäße Lösung wird für jede Beschichtungsanlage nur noch ein einziger Testglaswechsler benötigt, wobei das jeweils ausgewählte Testglas in gleicher Weise wie die Substrate kontinuierlich durch die einzelnen Beschichtungsstationen hindurchbewegt wird. Dadurch wird zunächst einmal der konstruktive Aufwand erheblich reduziert, da auch nur eine einzige Meßvorrichtung benötigt wird. Sofern man die Substrate auf einer Kreisbahn anordnet, in der auch das ausgewählte Testglas liegt, weisen sowohl das Testglas als auch sämtliche Substrate die gleichen Schichten und damit die gleichen Meßergebnisse bzw. Eigenschaften auf. Hierbei wird natürlich vorausgesetzt, daß sich der Stoffstrom von der Quelle während eines oder mehrerer Umläufe des Substrathalters nicht verändert, was jedoch in der Praxis leicht durchführbar ist. Die kontinuierliche Betriebsweise führt zu einer höheren Produktivität der Beschichtungsanlage, und es ist nicht erforderlich, das ausgewählte Testglas für die Dauer des Beschichtungsvorganges im Strahlengang der optischen Meßvorrichtung zu halten. Die Messung kann vielmehr während des Durchlaufs des Testglases durch den Strahlengang durchgeführt werden, wobei durch eine Synchronisationseinrichtung dafür gesorgt wird, daß während der Unterbrechung des Strahlengangs (außerhalb des Durchgangs des Testglases) eine Signalverarbeitung unterbleibt. Die Maßnahmen und Mittel hierfür sind dem Fachmann bekannt, so daß hierauf nicht näher eingegangen zu werden braucht.

Der Erfindungsgegenstand ist mit besonderem Vorteil bei solchen Beschichtungsverfahren einsetzbar, bei denen abwechselnd Schichten aus hoch- und niedrigbrechendem Material aufgebracht werden. Derartige Schichtfolgen werden auch als "Interferenzsysteme" bezeichnet.

Durch die bereits genannte DE-A-29 32 483 und die DE-A-27 50 421 der gleichen Anmelderin ist es weiterhin bereits bekannt, daß es bei solchen Schichtsytemen besonders vorteilhaft ist, die hochbrechenden Materialien jeweils auf ein Testglas und die niedrigbrechenden Materialien auf ein anderes Testglas aufzubringen, um hierdurch die nach Art von Sinuslinien schwankenden Transmissions- bzw. Reflexions-Verhältnisse weitgehend ungeschwächt über eine Vielzahl von Schichten messen zu können. Man läßt in einem solchen Falle beim Erfindungsgegenstand einfach die Substrate und eines der Testgläser durch den Strom eines Beschichtungsmaterials (z.B. mit hohem Brechungsindex) hindurchlaufen, wobei eine solche Schicht durch eine Vielzahl von Durchgängen auch aus identischen Einzelschichten aufgebaut werden kann. Während der weiteren Umläufe des Substrathalters unterbleibt in einem solchen Falle einfach die Umschlatung des Testglaswechslers durch Maßnahmen, die in der Detailbeschreibung noch näher erläutert sind. Erst beim Wechsel des Beschichtungsmaterials (z.B. auf ein solches mit einem niedrigen Brechungsindex) erfolgt eine Umschaltung auf ein anderes Testglas, auf dem nun eine oder mehrere Schichten aus dem betreffenden Material aufgebaut werden. Wird nachfolgend wiederum eine Schicht aus dem ersten Material aufgebracht, so kann beispielsweise eine Umschaltung auf das zuerst benutzte Testglas erfolgen, wenn beispielsweise der Testglaswechsler zwei Testgläser in symmetrischer Anordnung enthält. Man kann aber auch die Testgläser in einer Anzahl vorsehen, die einem geradzahligen Vielfachen der unterschiedlichen Schichtmaterialien entspricht, also beispielsweise vier Testgläser, so daß bei einem Wechsel des Schichtmaterial jeweils in gleicher Weise eine Fortschaltung der Testgläser erfolgt. Auch in diesem Falle werden die hochbrechenden Materialien einerseits und die niedrigbrechenden Materialien andererseits stets auf verschiedenen Testgläsern niedergeschlagen.

Der Erfindungsgegenstand bewährt sich aber auch und insbesondere bei solchen Schichten, die nur aus einer einzigen Substanz bestehen. In diesem Fall wird durch den erfindungsgemäßen Testgläswechsler ein Magazin für eine entsprechende Anzahl von Testgläsern zur Verfügung gestellt.

Es ist dabei besonders vorteilhaft, wenn die Halterung der Testgläser eine Kreisscheibe ist, die auf einem konzentrischen Kreis mehrere Ausnehmungen für die Testgläser aufweist, und wenn sie durch die Steuereinrichtung um eine zum Substrathalter festgelegte Achse nach Maßgabe des Winkelabstandes der Ausnehmungen intermittierend fortschaltbar ist und wenn sie durch eine Schutzvorrichtung abgedeckt ist, die jeweils nur ein einziges Testgläs in seiner Beschichtungs- und Meßposition freiläßt.

Ein solcher Testglaswechsler läßt sich durch eine Art Index-Vorrichtung, die in der Detailbeschreibung näher erläutert wird, auf einfachste Weise und durch eine Steuerung leicht beeinflußbar fortschalten.

Weitere vorteilhafte Ausgestaltungen des Erfindungsgegenstandes ergeben sich aus den übrigen Unteransprüchen.

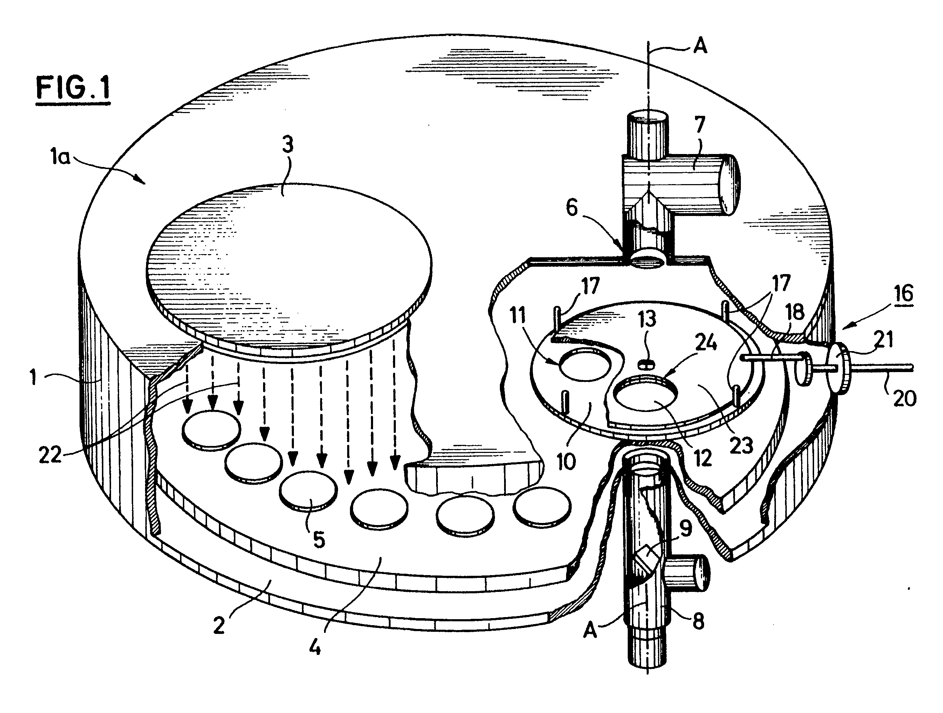

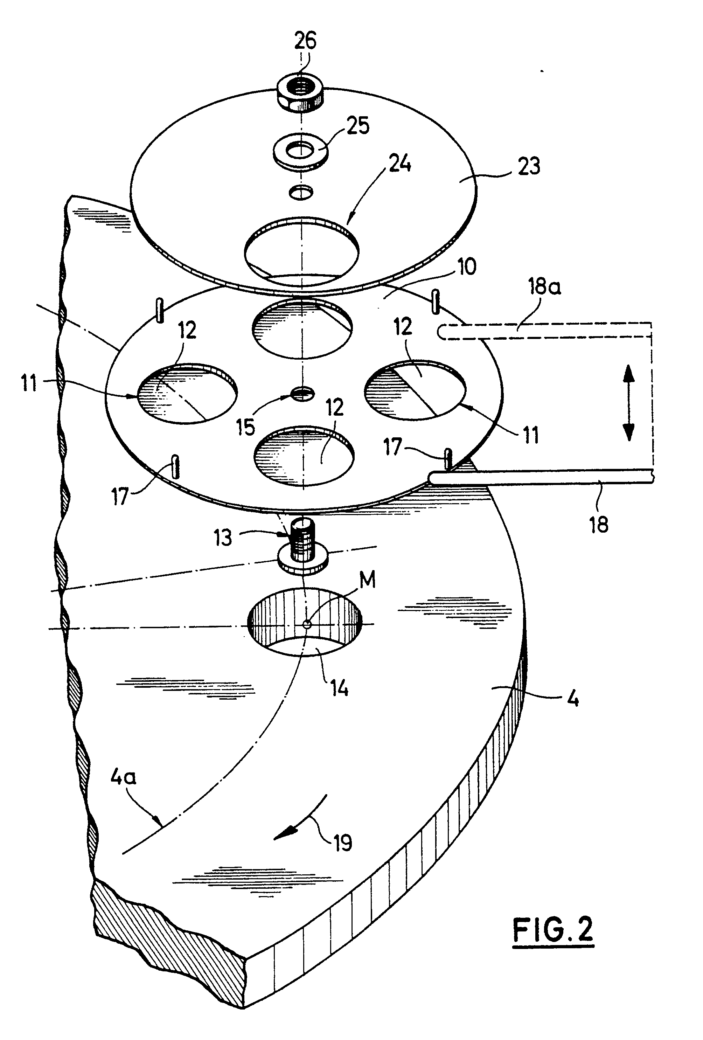

Ein Ausführungsbeispiel des Erfindungsgegenstandes wird nachfolgend anhand der Figuren 1 und 2 näher erläutert, die eine Vorrichtung mit einem drehbaren Substrathalter zeigt.

Es zeigen:

Figur 1    eine teilweise aufgebrochene perspektivische Darstellung einer vollständigen Vakuumbeschichtungsanlage mit dem erfindungsgemäßen Testglaswechsler und

Figur 2    eine Explosionsdarstellung des Testglaswechslers nach Figur 1 in Verbindung mit einem Teilausschnitt des Substrathalters.

In Figur 1 ist eine Vakuum-Beschichtungsanlage dargestellt, die als Katodenzerstäubungsanlage ausgeführt ist. Die Anlage weist eine zylindrische Vakuumkammer 1 auf, deren unterer Abschluß durch einen Boden 2 gebildet wird. In der Decke der Vakuumkammer ist eine Zerstäubungskatode 3 angeordnet, und es sei darauf hingewiesen, daß eine derartige Anlage auch mit zwei oder mehreren solcher Zerstäubungskatoden ausgerüstet sein kann. Im Boden 2 befindet sich eine hier nicht gezeichnete Drehlagerung für einen Substrathalter 4, der als kühlbare Kreisscheibe ausgebildet ist. Auf diesem Substrathalter liegen innerhalb einer konzentrischen, kreisförmigen Bewegungsbahn 4a (Figur 2) eine Reihe von Substraten 5, die durch Rotation des Substrathalters 4 durch den Strom eines Beschichtungsmaterials geführt werden, der von der Zerstäubungskatode 3 ausgeht.

In der Decke 1a der Vakuumkammer ist eine Öffnung 6 angeordnet. in die vakuumdicht eine Lichtquelle 7 eingesetzt ist, die die optische Achse A-A eines Strahlenganges definiert. An einer koaxial gegenüberliegenden Stelle befindet sich im Boden 2 eine weitere Öffnung, in die vakuumdicht und mit gleichem Strahlengang ein Empfängerteil 8 mit einem Fotosensor 9 eingesetzt ist. Lichtquelle 7 und Empfängerteil 8 bilden zusammen eine optische Meßvorrichtung, deren Strahlengang bzw. optische Achse A-A in der Bewegungsbahn 4a der Substrate 5 liegt.

Am Substrathalter 4 ist auf dessen Oberseite exzentrisch eine Halterung 10 drehbar gelagert, die als Kreisscheibe ausgebildet ist und auf einem konzentrischen Kreis in äquidistanter Anordnung mehrere Ausnehmungen 11 für eine Anzahl von Testgläsern 12 aufweist. Die Halterung 10 ist um eine Achse 13 drehbar, die ihrerseits fest mit dem Substrathalter 4 verbunden ist.

Wie unter Hinzunahme der Figur 2 erkennbar ist, befindet sich im Substrathalter 4 eine Durchbrechung 14 deren Mittelpunkt M auf der gleichen Bewegungsbahn 4a liegt wie die Mittelpunkte der Substrate 5. Die Halterung 10 ist mittels einer zentralen Bohrung 15 auf die Achse 13 aufsteckbar, wobei die Anordnung so getroffen ist, daß jede der Ausnehmungen 11 in der Halterung 10 durch deren Drehung in eine kongruente Lage mit der Durchbrechung 14 gebracht werden kann. Dieses Fortschalten geschieht durch eine als Schrittschaltwerk ausgebildete Steuereinrichtung 16, zu der eine Anzahl von stiftförmigen Vorsprüngen 17 gehört, die mit einem beweglichen Schaltfinger 18 zusammenwirken. Die Vorsprünge 17 entsprechen in ihrer Zahl der Zahl der Ausnehmungen 11 bzw. der Testgläser 12 und sind an der Peripherie der Halterung 10 im gleichen Winkelabstand angeordnet wie die Ausnehmungen. Der Schaltfinger 18 ragt in seiner einen möglichen Stellung in die Umlaufbahn des jeweils am weitesten außen liegenden Vorsprunges 17 um den Mittelpunkt des Substrathalters 4 hinein. Wenn sich der in Figur 2 sichtbare rechte Rand des Substrathalters 4 in Richtung des Pfeils 19 nach vorn dreht, dann stößt der unmittelbar vor dem Schaltfinger 18 liegende Vorsprung 17 gegen den Schaltfinger 18 und wird so lange festgehalten, bis er nach einer Drehung der Halterung 10 um 90 Grad (360 Grad: Anzahl der Ausnehmungen 11) wieder von dem Schaltfinger 18 abgleitet. Dabei verläßt ein Testglas 12 seine Kongruenzlage mit der Durchbrechung 14, und das nachfolgende Testglas 12 rückt an seine Stelle. Die Halterung 10 wird also bei einer geringfügigen Drehbewegung des Substrathalters 4 um denjenigen Winkelabstand fortgeschaltet, der zwischen zwei unmittelbar benachbarten Ausnehmungen 11 liegt. Auf dem Rest der Drehbewegung des Substrathalters 4 wird die Halterung 10 in Ruhelage gegenüber dem Substrathalter gehalten.

Der Schaltfinger 18 ist aus der ausgezogen dargestellten Position vertikal nach oben in die gestrichelt dargestellte Position 18a anhebbar, in der er nicht mehr in die Umlaufbahn jeweils eines der Vorsprünge 17 hineinragt. In diesem Fall unterbleibt somit eine Fortschaltung, und man hat es hierdurch in der Hand, die Fortschaltung des Testglaswechslers während einer vorgebbaren Anzahl von Umdrehungen des Substrathalters zu unterbinden. Eine Möglichkeit der Bewegung des Schaltfingers 18 ist wiederum in Figur 1 dargestellt, und zwar ist dieser Schaltfinger exzentrisch an einer Welle 20 befestigt, die durch eine vakuumdichte Drehdurchführung 21 in das Innere der Vakuumkammer 1 führt. Das jeweils "ausgewählte Testglas" ist dasjenige, welches sich zum Zwecke einer Beschichtung und Messung in Kongruenzlage mit der Durchbrechung 14 befindet.

Die vertikalen gestrichelten Pfeile in Figur 1 symbolisieren den Strom 22 des Beschichtungsmaterials.

Die Halterung 10 ist durch eine Schutzvorrichtung 23 abgedeckt, die jeweils nur ein einziges Testglas 12 in seiner Beschichtungs- und Meßposition frei läßt. Die Schutzvorrichtung ist dabei eine koaxial auf der Halterung 10 der Testgläser 12 aufliegende, gegenüber dem Substrathalter 4 unverdrehbare Kreisscheibe, die eine einzige, mit je einem der Testgläser 12 zur Deckung bringbare Öffnung 24 aufweist. Die Schutzvorrichtung 23 wird verdrehfest auf der Achse 13 durch eine Unterlegscheibe 25 und eine Mutter 26 festgelegt, und zwar in Kongruenzlage zur Durchbrechung 14.

Wie speziell aus Figur 1 hervorgeht, ist der Durchmesser der Schutzvorrichtung um ein solches Maß gegenüber dem Durchmesser der Halterung 10 kleiner, daß die Vorsprünge 17 ungehindert um die Schutzvorrichtung 23 umlaufen können.

Der beschriebene Testglaswechslers ermöglicht es, daß die Substrate und das jeweils ausgewählte Testglas nacheinander auf dem gleichen Wege durch den Strom 22 des Beschichtungsmaterials bewegt werden, so daß an den Substraten und am Testglas identische Bedingungen gegeben sind. Die Testglashalterung wird beim Eingriff der Steuereinrichtung 16 nur innerhalb eines im Verhältnis zu einer vollen Umdrehung des Substrathalters kleinen Drehwinkels fortgeschaltet, befindet sich aber auf dem allergrößten Teil des Umfangsweges des Substrathalters gegenüber diesem in Ruhe.

Während des Durchlaufs des ausgewählten Testglases durch die optische Achse A-A der Meßvorrichtung werden die Schichteigenschaften am Testglas gemessen, wobei bereits aufgrund der weiter oben beschriebenen Synchronisationsschaltung die kurze zur Verfügung stehende Zeitspanne für die optische Abtastung des Testglases vollkommen ausreicht.

Während Figur 1 eine Meßvorrichtung für eine sogenannte Transmissionsmessung zeigt, ist es selbstverständlich möglich, Lichtquelle und Empfängerteil auf ein und derselben Seite des Testglaswechslers anzuordnen, so daß auch eine sogenannte Reflexionsmessung möglich ist. Bei Reflexionsmessungen von oben kann auf die Durchbrechung im Substrathalter verzichtet werden, was beim Anlegen einer Bias-Spannung an den Substrathalter weitere Vorteile bietet.

**Patentansprüche**

1. Testglaswechsler zur optischen Messung von Schichteigenschaften in Vakuum-Beschichtungsanlagen, die einen beweglichen Substrathalter (4) für die Führung mindestens eines Substrats (6) auf einer Bahn durch mindestens einen Strom (22) eines Beschichtungsmaterials aufweisen, mit einer am Substrathalter gelagerten und mit diesem beweglichen und relativ zum Substrathalter in sich beweglichen Halterung (10) für die Aufnahme mehrerer Testgläser (12) und mit einer Steuereinrichtung (16) für die Einführung jeweils eines Testglases (12) in einen Strahlengang einer Meßvorrichtung (7,8) und in den mindestens einen Strom des Beschichtungsmaterials, dadurch gekennzeichnet, daß die Steuereinrichtung (16) ein Schrittschaltwerk ist, durch das bei einem im Verhältnis zu einer vollen Bahnlänge des Substrathalters (4) kleinen Weg jeweils ein Testglas (12) in eine relativ zum Substrathalter (4) stationäre Position umschaltbar ist, in der es mit dem Substraten (6) für eine vorgebbare Anzahl von Bewegungen des Substrathalters alternierend nacheinander durch den Strahlengang (A-A) der Meßvorrichtung (7, 8) und durch den Strom (22) des Beschichtungsmaterials hindurchführbar ist.

2. Testglaswechsler nach Anspruch 1, dadurch gekennzeichnet, daß die Halterung (10) der Testgläser (12) eine Kreisscheibe ist, die auf einem konzentrischen Kreis mehrere Ausnehmungen (11) für die Testgläser aufweist und durch die Steuereinrichtung (16) um eine zum Substrathalter (4) festgelegte Achse (13) nach Maßgabe des Winkelabstandes der Ausnehmungen intermittierend fortschaltbar ist und daß sie durch eine Schutzvorrichtung (23) abgedeckt ist, die jeweils nur ein einziges Testglas (12) in seiner Beschichtungs- und Meßposition frei läßt.

3. Testglaswechsler nach Anspruch 2, dadurch gekennzeichnet, daß die Schutzvorrichtung (23) eine koaxial auf der Halterung (10) der Testgläser (12) aufliegende, gegenüber dem Substrathalter (4) unverdrehbare Kreisscheibe ist, die eine einzige, mit je einem der Testgläser (12) zur Deckung bringbare Öffnung (24) aufweist.

4. Testglaswechsler nachAnspruch 3, dadurch gekennzeichnet, daß der Substrathalter (4) an der Stelle der Öffnung (24) in der Schutzvorrichtung (23) eine Durchbrechung (14) aufweist.

5. Testglaswechsler nach Anspruch 2, dadurch gekennzeichnet, daß die Steuereinrichtung (16) aus einer der Anzahl der Ausnehmungen (11) entsprechenden Zahl von Vorsprüngen (17) besteht, die in der Peripherie der Halterung (10) im gleichen Winkelabstand angeordnet sind wie die Ausnehmungen, sowie aus einem in die jeweiligen Umlaufbahn der Vorsprünge (17) hineinbewegbaren Schaltfinger (18), durch den die Halterung (10) um einen Winkelabstand zwischen zwei Ausnehmungen (11) fortschaltbar ist.

**Claims**

1. Test glass changer for the optical measurement of layer properties in vacuum coating apparatuses, which have a moving substrate support (4) for guiding at least one substrate (6) on a path through at least one stream (22) of a coating material, with a mount (10) for receiving a plurality of test glasses (12), which is mounted on the substrate support and is movable therewith and movable *per se* relative to the substrate support, and with a control device (16) for introducing one test glass (12) at a time into the ray path of a measuring device (7, 8) and into the stream (of which there is at least one) of coating material, characterised in that the control device (16) is a stepper switchgear, by means of which one test glass (12) at a time can be moved into a stationary position relative to the substrate support (4) by a distance which is small compared to a full path length of the substrate support (4), in which position the test glass can be passed with the substrates (6) alternately through the ray path (A-A) of the measuring device (7, 8) and through the stream (22) of coating material for a specifiable number of rotations of the substrate support.

2. Test glass changer according to claim 1, characterised in that the mount (10) of the test glasses (12) is a circular disc, which has a plurality of recesses (11) for the test glasses on a concentric circle, and which can be intermittently moved on by the control device (16) about a shaft (13) fixed to the substrate support (4) according to the angular distance of the recesses, and in that said mount (10) is covered by a protective device (23), which exposes only one test glass (12) at a time in its coating and measuring position.

3. Test glass changer according to claim 2, characterised in that the protective device (23) is in this case a circular disc, which rests coaxially on the mount (10) of the test glasses (12) and is non-rotatable relative to the substrate support (4), and which has a single aperture (24) capable of covering one of the test glasses (12) at a time.

4. Test glass changer according to claim 3, characterised in that the substrate support (4) has a hole (14) at the place of the aperture (24) in the protective device (23).

5. Test glass changer according to claim 2, characterised in that the control device (16) consists of a number of projections (17) corresponding to the number of recesses (11), and the projections (17) are arranged around the periphery of the mount (10) with the same angular spacing as the recesses, and of a switch finger (18), which is movable into the respective path of rotation of the projections (17) and by means of which the mount (10) can be moved on by the angular distance between two recesses (11).

**Revendications**

1. Changeur de verres d'essai destiné à la mesure optique des caractéristiques de couches, dans les installations de vaporisation sous vide, possédant un porte-substrat mobile (4) guidant au moins un substrat (6) sur une trajectoire traversant au moins un flux (22) d'un matériau de revêtement, avec une monture (10), montée sur le porte-substrat et se déplaçant avec lui ainsi que relativement par rapport à lui, qui reçoit plusieurs verres d'essai (12), et avec un dispositif de commande (16) pour l'introduction d'un verre d'essai (12) à la fois dans la trajectoire des rayons d'un dispositif de mesure (7, 8) et dans le flux au moins unique du matériau de revêtement, caractérisé en ce que le dispositif de commande (16) est un mécanisme pas à pas qui permet, en effectuant une course relativement petite par rapport à la longueur de course du porte-substrat (4), de placer un verre d'essai (12) dans une position stationnaire par rapport au porte-substrat (4) où il peut effectuer avec les substrats (6) un nombre prédéterminé de mouvements du porte-substrat, en passant alternativement et successivement dans la trajectoire des rayons (A-A) du dispositif de mesure (7, 8) et dans le flux (22) du matériau de revêtement.

2. Changeur de verres d'essai selon la revendication 1, caractérisé en ce que la monture (10) des verres d'essai (12) est un disque circulaire présentant sur un cercle concentrique plusieurs logements (11) pour recevoir les verres d'essai (12) et pouvant être avancé par intermittence par le dispositif de commande (16) autour d'un axe (13) fixe par rapport au porte-substrat (4) en fonction de la distance angulaire entre les logements et en ce qu'elle est recouverte par un dispositif de protection (23) qui ne dégage qu'un seul verre d'essai (12) dans sa position de revêtement et de mesure.

3. Changeur de verres d'essai selon la revendication 2, caractérisé en ce que le dispositif de protection (23) est un disque circulaire monté coaxialement sur la monture (10) des verres d'essai (12), fixe par rapport au porte-substrat (4) et ne présentant qu'une seule ouverture (24) pouvant être amenée en coïncidence avec l'un des verres d'essai (12).

4. Changeur de verres d'essai selon la revendication 3, caractérisé en ce que le porte-substrat (4) présente une traversée (14) à l'endroit de l'ouverture (24) dans le dispositif de protection (23).

5. Changeur de verres d'essai selon la revendication 2, caractérisé en ce que le dispositif de commande (16) se compose d'un nombre de saillies (17) correspondant au nombre des logements (11), ces saillies étant disposées à la périphérie de la monture (10) à des distances angulaires identiques à celles des logements, ainsi que d'un doigt de commande (18) pouvant s'intercaler sur la trajectoire des saillies (17), si bien que la monture (10) peut être avancée d'une distance angulaire entre deux logements (11).

FIG.1

EP 0 241 589 B1

**FIG.2**